# EUROPÄISCHE PATENTSCHRIFT

(11) **EP 1 722 614 B1**
(45) Veröffentlichungstag und Bekanntmachung des Hinweises auf die Patenterteilung: **12.12.2007**
(21) Anmeldenummer: 05010475.1
(22) Anmeldetag: 13.05.2005
(51) Int. Cl.: H05K 3/10, D03D 15/00, H05K 1/00

(54) **Leiterplatte und Verfahren zu deren Herstellung**
Wiring board and method of manufacturing the same
Carte électronique et son procédé de fabrication

(43) Veröffentlichungstag der Anmeldung: 15.11.2006
(73) Patentinhaber: Sefar AG, 8803 Rüschlikon (CH)
(72) Erfinder: Kirstein, Tünde, 8953 Dietikon (CH); Locher, Ivo, 6300 Zug (CH); Maurer, Christoph, 8044 Zürich (CH)
(74) Vertreter: Wunderlich, Rainer

(56) Entgegenhaltungen:
- WO-A-01/36728
- WO-A-03/021312
- WO-A-20/04107831
- DE-A1- 10 338 029
- US-A1- 2004 259 391
- US-A1- 2005 069 695
- US-B1- 6 210 771

## Beschreibung

Die Erfindung betrifft eine hochflexible Leiterplatte mit elektrisch nicht-leitenden Fäden und elektrisch leitenden Fäden. Weiterhin betrifft die Erfindung ein Verfahren zur Herstellung einer hochflexiblen Leiterplatte, welche elektrisch nicht-leitende Fäden und elektrisch leitende Fäden aufweist.

Die Benutzung von elektrischen Geräten im täglichen Leben nimmt stetig zu. So führen bereits ein Großteil der Bevölkerung Mobiltelefone, PDA's oder MP3-Player dauerhaft mit sich. Neben der Miniaturisierung der Geräte wird verstärkt versucht, Funktionen der Geräte in Textilien zu integrieren. Beispielsweise sollen Textilien mit elektrischen und elektronischen Funktionen ausgestattet werden. Wichtig ist hierbei jedoch, dass die grundlegenden Eigenschaften der Textilien, wie beispielsweise der Tragekomfort nicht maßgeblich beeinflusst werden.

Aus der WO 03/052541 A2 und der US 2002/0259391 A1 sind Textilien bekannt, die einzelne elektrische Leiterbahnen aufweisen. Diese Leiterbahnen sind in die Textilien gezielt eingebracht, um bestimmte elektrische Komponenten, beispielsweise IC's anzuschließen bzw. zu verbinden.

Die bekannten Textilien sind nur punktuell mit Leiterbahnen versehen, die jeweils nur für einen speziellen Verwendungszweck optimiert angeordnet sind. Die Leiterbahnen stellen Punkt-zu-Punkt-Verbindungen dar, wie sie von der fliegenden Verdrahtung aus der Elektronik bekannt sind. Deshalb muss für jede neue Funktion, die in ein Textil integriert werden soll, ein neuer Stoff mit entsprechenden Leiterbahnen hergestellt werden. Oft werden diese Leiterbahnen deshalb nachträglich auf das Textil auf- bzw. eingebracht, beispielsweise durch Aufdruck oder Einnähen dieser Leiterbahnen. Dies ist zum einen aufwändig, zum anderen sind die dadurch entstandenen Schaltungen oft nicht besonders widerstandsfähig und funktionieren nach kurzer Zeit nicht mehr korrekt.

Aus der US 2004/259 391 A1 ist ein Verfahren bekannt, um in einem Gewebe verlaufende elektrische Leitungen mit einem elektronischen Bauelement zu verbinden. Diese elektrischen Leitungen können sowohl in Schuss- als auch in Kettrichtung in dem Gewebe verlaufen.

Die WO 01/36728 A beschreibt ein Band, welches Daten- und/oder Energiebusleitungen beinhaltet. Dieses Band besteht aus einem Gewebe, welches in Schuss- und/oder Kettrichtung elektrisch leitende Fasern aufweise kann, um den Bus auszubilden.

Herkömmliche Leiterplatten oder Platinen sind nur bedingt zur Integration in Textilien einsetzbar. Sie sind steif und starr. Sollen Funktionen in Textilien integriert werden, indem herkömmliche Leiterplatten verwendet werden, so verliert das Textil schnell die textilen Eigenschaften, wie den Tragekomfort. Auch andere Leiterplatten, beispielsweise auf Folien, sind nur bedingt zur Integration in Textilien anwendbar. Obwohl die Folien bereits eine Verbesserung zu den herkömmlichen starren Leiterplatten darstellen, verschlechtern sie die textilen Eigenschaften in einer ungewollten Form.

Der Erfindung liegt die **Aufgabe** zugrunde, eine Leiterplatte und ein Verfahren zu deren Herstellung anzugeben, die einfach mit herkömmlichen Textilien kombinierbar ist, ohne die textilen Eigenschaften zu verschlechtern.

Die Aufgabe wird erfindungsgemäß durch eine Leiterplatte mit den Merkmalen des Anspruchs 1 und zum anderen durch ein Verfahren mit den Merkmalen des Anspruchs 13 gelöst. Bevorzugte Ausführungsformen sind in den jeweiligen abhängigen Ansprüchen angegeben.

Bei der hochflexiblen Leiterplatte sind elektrisch nicht-leitende Fäden und elektrisch leitende Fäden, die mit einem elektrisch isolierenden Material ummantelt sind zu einem Gewebe verwebt, wobei mindestens die elektrisch leitenden Fäden als Kett- und Schussfäden angeordnet sind und eine regelmäßige Gitterstruktur im gesamten Gewebe bilden. Ferner weisen die elektrisch nicht-leitenden Fäden eine höhere Zugfestigkeit als die elektrisch leitenden Fäden auf.

Ein Grundgedanke der Erfindung kann darin gesehen werden, nicht mehr für jeden Verwendungszweck spezielle Leiterbahnen in ein Textil ein- oder aufzubringen, sondern eine textilähnliche Leiterplatte zu verwenden, welche mit einem herkömmlichen Textil kombiniert wird. Diese Leiterplatte weist eine regelmäßige Verteilung von elektrisch leitenden Fäden auf, die sich über die gesamte Leiterplatte erstrecken. Da elektrisch leitende Fäden sowohl als Kett- als auch als Schussfäden verwendet werden, entsteht ein sich über die gesamte Leiterplatte erstreckendes Raster. Durch eine Verbindung von leitenden Schussfäden mit leitenden Kettfäden können zwei beliebige Stellen auf der Leiterplatte ohne zusätzliche Verdrahtung verbunden werden. Ungewollte Verbindungen werden durch die Isolation verhindert. So kann die hochflexible Leiterplatte verwendet werden, um elektrische und elektronische Bauelemente aufzubringen und beliebig zu verbinden, ähnlich bekannter herkömmlicher Leiterplatten.

Ein weiterer Grundgedanke der Erfindung ist, dass die elektrisch nicht-leitenden Fäden und die elektrisch leitenden Fäden eine unterschiedliche Zugfestigkeit aufweisen. Durch die höhere Zugfestigkeit der nicht-leitenden Fäden kann erreicht werden, dass bei einer Beanspruchung der Leiterplatte die elektrisch leitenden Fäden vor Zugkräften weitgehend geschützt werden. Hierdurch wird ein Reißen der elektrisch leitenden Fäden und somit eine elektrische Unterbrechung der durch sie dargestellten Verbindungen vermieden. Eine Unterbrechung führt meist zu einem Ausfall der auf der Leiterplatte realisierten Verschaltung.

Da die erfindungsgemäße Leiterplatte aus gewebten Fäden entsteht, ist sie hochflexibel. Sie weist ähnliche Eigenschaften in Bezug auf Faltbarkeit, Gewicht und sonstigem Verhalten wie herkömmliche Textilien auf. Dadurch ist sie hervorragend zur Kombination mit Textilien geeignet.

Grundsätzlich können die elektrisch nicht-leitenden und die elektrisch leitenden Fäden jeden beliebigen Durchmesser aufweisen. Es hat sich aber als besonders vorteilhaft herausgestellt, wenn sie einen Durchmesser zwischen 0,5 µm bis 500 µm besitzen. Durch die Verwendung derart dünner Fäden wird erreicht, dass die Leiterplatte äußerst flexibel ist. So werden die textilen Eigenschaften eines mit der Leiterplatte verbundenen Textils nicht beeinflusst. Eine weitere Verringerung des Durchmessers der Fäden führt dazu, dass die elektrisch leitenden Fäden einen höheren Widerstand aufweisen, worauf bei der Verschaltung geachtet werden muss.

Nach der Erfindung ist es besonders vorteilhaft, wenn das Gewebe eine Maschenweite von 1 µm bis 1 mm aufweist und eine Dicke von 1 µm bis 1 mm. Durch eine derartig geringe Maschenweite wird erreicht, dass genügend Leiterbahnen in Schuss- und Kettrichtung zur Verfügung stehen. Hierdurch können selbst komplizierte Verschaltungen elektrischer Bauelemente auf engstem Raum ausgeführt werden. Durch die geringe Dicke der erfindungsgemäßen Leiterplatte wird ein mit dieser verbundenes Textil nicht in den textiltypischen Eigenschaften beeinflusst. Für spezielle Anwendungszwecke sind auch größere und kleinere Maschenweiten bzw. Dicken möglich.

Außerdem ist das Gewebe bedingt durch die geringe Maschenweite, den geringen Fadendurchmesser und die geringe Dicke äu-ßerst fein. Diese Feinheit ermöglicht den flexiblen Einsatz der Leiterplatte. Sie kann problemlos in das Innenfutter von Kleidungsstücken eingebracht werden, ohne dass sie vom Träger der Kleidung negativ bemerkt wird.

Die elektrisch leitenden Fäden können beispielsweise aus elektrisch leitendem Kunststoff oder Ähnlichem hergestellt werden. In einer bevorzugten Ausführungsform weisen sie einen Kern auf. Kupfer eignet sich hierfür besonders gut aufgrund der hohen elektrischen Leitfähigkeit und der geringen Kosten im Vergleich zu Edelmetallen. Andere hierfür geeignete Materialien sind beispielsweise Messing, Aluminium oder Polypyrrol, ein leitender Kunststoff. Ein geringer spezifischer Widerstand ist für die Leiterplatte vorteilhaft, da sie sich zum einen nicht erwärmen soll, zum anderen notwendig da bei der Verwendung mit Textilien meist nur eine mobile Energiequelle zur Verfügung steht, die eine begrenzende Leistung hat.

Eine ganz erhebliche Erhöhung der elektrischen Leitfähigkeit wird erfindungsgemäß erreicht, indem der Kern der elektrisch leitenden Fäden mit Silber und/oder Gold überzogen ist. Hierdurch wird zum einen der Kern geschützt, beispielsweise vor Oxidation. Zum anderen wird die elektrische Leitfähigkeit des entstandenen leitenden Fadens dadurch weiter erhöht, wodurch wenige Energieverluste bei langen Leiterbahnen auftreten. Zudem kann eine deutlich bessere Kontaktierung bei der punktuellen Verbindung einzelner leitender Fäden erzielt werden.

Die elektrisch leitenden Fäden werden sowohl als Schuss- als auch als Kettfäden eingesetzt. Um zu verhindern, dass die leitenden Fäden untereinander elektrisch leitend an den Schnittstellen verbunden sind, weisen sie eine Isolation auf.

Besonders bevorzugt ist es, wenn diese Isolation aus Kunststoff, insbesondere aus Polyethylen, Polyurethan, Polyester oder Polyamid ausgeführt ist. Kunststoff besitzt den Vorteil, dass er leicht, beispielsweise mit einem Laser, entfernt werden kann. Hierdurch kann punktuell eine gewollte Verbindung zwischen zwei leitenden Fäden erzeugt werden. Andere Materialien zur Isolation sind ebenso möglich. Bevorzugt werden Materialien, die in der Produktion den leitenden Faden leicht ummanteln können und später einfach punktuell entfernt werden können.

Grundsätzlich kann die Leiterplatte aus monofilen Fäden aufgebaut sein. Um die Festigkeit zu erhöhen, hat es sich aber als vorteilhaft herausgestellt, dass das Gewebe Multifilamentfäden aufweist, welche aus den elektrisch nicht-leitenden und/oder elektrisch leitenden Fasern aufgebaut sind. Hierdurch ist es ebenso möglich, die Struktur der Leiterplatte besonders einfach zu variieren. Auch die Zugfestigkeit in eine bestimmte Richtung kann hierdurch beeinflusst werden. Ebenso ist eine Kombination von Mono- und Multifilamentfäden möglich.

In einer besonders bevorzugten Ausführungsform weist die Gitterstruktur der Leiterplatte, die durch die leitenden Fäden gebildet wird, in Schuss- wie in Kettrichtung den gleichen Abstand auf. Dieser Abstand ist bevorzugt zwischen 5 µm und 4 mm groß. Durch einen regelmäßigen gleichen Abstand wird erreicht, dass ein regelmäßiges Raster von leitenden Fäden ausgebildet wird. Hierdurch ist es einfacher, Computerprogramme zu entwickeln, die eine Verschaltung und Anordnung verschiedener Bauelemente auf der Leiterplatte automatisiert ermitteln. Durch die bevorzugte Größenordnung des Rasters wird die notwendige Anzahl an elektrisch leitenden Fäden mit einer notwendigen Anzahl an nicht-leitenden Fäden, die für die Festigkeit zuständig sind, kombiniert. Aufgrund der hohen Feinheit des Rasters stehen ausreichend elektrisch leitende Fäden zur Verfügung, um auch komplexe Verschaltungen zu realisieren.

Um eine genügend große Festigkeit der Leiterplatte zu erreichen, hat es sich als vorteilhaft herausgestellt, dass mehr nicht-leitende als leitende Fäden in dem entstehenden Gewebe vorzusehen sind. Das Verhältnis der leitenden und nicht-leitenden Fäden zueinander kann an den jeweiligen Verwendungszweck angepasst werden. So können eine größere Anzahl an leitenden Fäden in das Gewebe eingewebt werden, wenn eine komplizierte Verschaltung ausgeführt werden soll, die viele Leiterbahnen benötigt. Wird die Anzahl der nicht-leitenden Fäden erhöht, wird die Leiterplatte zugfester, und somit robuster.

In einer besonders bevorzugten Ausführungsform ist mindestens ein Adapterelement auf der Leiterplatte in elektrisch leitendem Kontakt mit mindestens einem der elektrisch leitenden Fäden angebracht. Außerdem ist auf dem Adapterelement ein elektrisches und/oder elektronisches Bauteil befestigt. Ein derartiges Adapterelement wird benötigt, da eine direkte Kontaktierung der elektrisch leitenden Fäden durch ein Bauteil aufgrund der hohen Feinheit des Gewebes nur schwierig möglich ist. Mit Hilfe des Adapterelementes wird erreicht, dass nur genau ein leitender Faden jeweils kontaktiert wird, und es nicht zu einer Doppel- oder Fehlkontaktierung kommt, welche einen Kurzschluss ausbilden kann. Auf diesem Adapterelement kann das elektronische Bauelement problemlos angebracht werden. Außerdem ist das elektronische Bauelement über das Adapterelement, welches eine größere Kontaktfläche mit der Leiterplatte als das Bauelement aufweist, besser mit der Leiterplatte verbunden.

Gemäß der Erfindung ist weiterhin ein Textil aus mindestens zwei Lagen vorgesehen, wobei mindestens eine Lage aus einer erfindungsgemäßen Leiterplatte aufgebaut ist. Durch diese Kombination wird erreicht, dass ein Textil mit elektronischen Funktionen versehen werden kann, ohne dass die textilen Eigenschaften verloren gehen. Die erfindungsgemäße Leiterplatte kann mit dem Textil beispielsweise durch Einlaminierung verbunden werden. Ebenso ist es möglich, die erfindungsgemäße Leiterplatte, mit einer darauf aufgebauten Verschaltung von elektronischen Bauelementen, in das Futter eines mehrlagigen Textils zu integrieren.

Besonders bevorzugt ist, wenn mindestens eine Lage des Textils aus einer Folie, einem Gewebe oder einem Filz besteht. Diese Lage kann als Trägermaterial für die hochflexible Leiterplatte dienen. Je nach Verwendungszweck besteht das Textil aus mehreren Lagen oder nur diesen zwei Lagen. Es ist vorteilhaft, wenn das Textil aus mindestens drei Lagen besteht, wobei die mittlere Lage durch die Leiterplatte gebildet wird, die dann besonders geschützt angebracht ist.

Bei dem erfindungsgemäßen Verfahren zur Herstellung der hochflexiblen Leiterplatte werden elektrisch nicht-leitende Fäden und elektrisch leitende Fäden, die mit elektrisch isolierendem Material ummantelt sind, zu einem Gewebe verwebt, wobei mindestens die elektrisch leitenden Fäden als Kett- und Schussfäden angeordnet werden und eine regelmäßige Gitterstruktur im gesamten Gewebe bilden.

Mit diesem Verfahren lässt sich die eingangs beschriebene hochflexible Leiterplatte besonders einfach und zuverlässig herstellen. Prinzipiell kann die Herstellung mit herkömmlichen Webmaschinen vorgenommen werden. Durch die Feinheit der verwendeten Fäden und die geringe Maschenweite ist es aber bevorzugt, wenn es sich hierbei um speziell für diesen Zweck optimierte Webmaschinen handelt.

Zum Aufbauen einer gewünschten Leitungsstruktur werden bestimmte elektrisch leitende Fäden getrennt oder verbunden. Zum Verbinden zweier elektrisch leitender Fäden werden diese beiden Fäden an ihrer Schnittstelle, beispielsweise durch einen Laser, abisoliert, indem die Isolation etwa verdampft wird. Anschließend werden die beiden Fäden an der abisolierten Stelle z.B. durch einen leitenden Kleber verbunden. Zum Schutz der Verbundstelle kann diese noch zusätzlich mit Kunststoff verhärtet werden. Ein Trennen eines elektrisch leitenden Fadens kann ebenfalls durch einen Laser erfolgen. Um eine Kontaktierung der beiden getrennten Enden eines Fadens zu verhindern, wird an der Trennungsstelle ein isolierender Kunststoff auf beide Enden aufgebracht. Da die Stabilität der Leiterplatte durch den Schnitt verringert wurde, ist es zweckmäßig, den isolierenden Kunststoff so aufzubringen, dass er beide Enden umschließt. So wird die Stabilität wieder erhöht.

Die Erfindung wird nachfolgend anhand von Ausführungsformen weiter erläutert, welche schematisch in den Zeichnungen dargestellt sind. In den Zeichnungen zeigen:
- Fig. 1: eine erfindungsgemäße Leiterplatte mit elektrisch leitenden und nicht-leitenden Fäden;
- Fig. 2: eine Verbindungsanordnung zwei elektrischer Komponenten auf einer erfindungsgemäßen Leiterplatte;
- Fig. 3: das Aufbringen einer elektrischen Komponente mit einem Adapterelement auf einer erfindungsgemäßen Leiterplatte; und
- Fig. 4: eine erfindungsgemäße Leiterplatte mit zwei angebrachten elektrischen Komponenten.

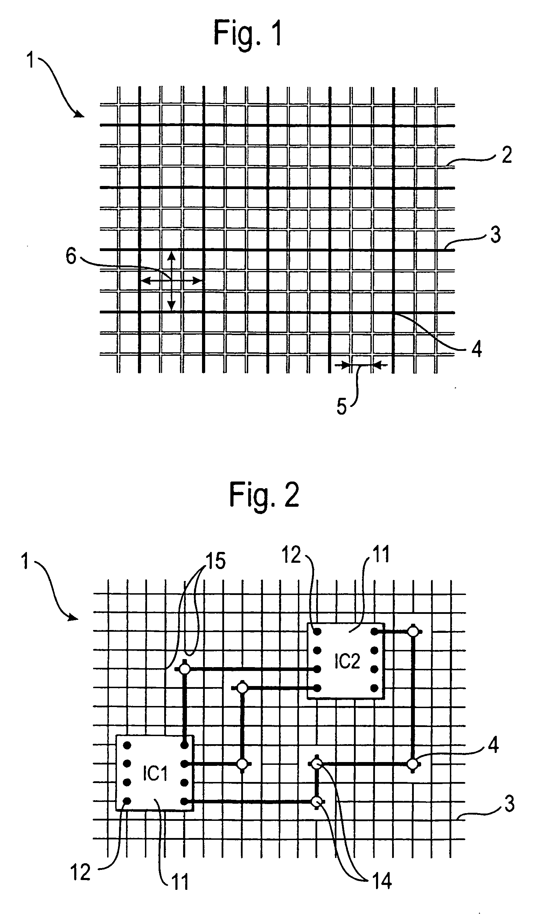

In Fig. 1 ist eine schematisierte Darstellung einer erfindungsgemäßen Leiterplatte 1 dargestellt. Die Leiterplatte 1 besteht aus elektrisch nicht-leitenden Fäden 2 und elektrisch leitenden Fäden 3. Elektrisch nicht-leitende Fäden 2 sind in dieser Fig. grau dargestellt, während elektrisch leitende Fäden 3 schwarz gezeichnet sind. Die Fäden 2, 3 bilden ein regelmäßiges Raster. Das Gewebe, welches durch die elektrisch nicht-leitenden und elektrisch leitenden Fäden 2, 3 entstanden ist, weist eine regelmäßige Maschenweite 5 auf.

Da in der Leiterplatte 1 mehr elektrisch nicht-leitende Fäden 2 eingewebt sind als elektrisch leitende Fäden 3, ist der Abstand 6 zwischen den elektrisch leitenden Fäden 3 größer als die Maschenweite 5. In diesem Fall beträgt das Verhältnis 3:1. Je mehr nicht-leitende Fäden 2 eingewebt sind, umso zugfester ist das Gewebe, das die Leiterplatte 1 bildet.

Die elektrisch leitenden Fäden 3 bestehen aus einem Kupferkern, der mit einem dünnen Gold- oder Silberfilm überzogen ist. Der so entstehende Faden ist wiederum mit einer isolierenden Schicht ummantelt. Bedingt durch die isolierende Schicht der leitenden Fäden 3 findet an den Schnittstellen 4 zweier elektrisch leitender Fäden 3 kein elektrischer Kontakt zwischen diesen beiden Fäden 3 statt.

In Fig. 2 ist die grundsätzliche Anordnung von zwei elektrischen Bauelementen 11 auf einer erfindungsgemäßen Leiterplatte 1 dargestellt. In dieser Figur sind nur die leitenden Fäden 3 dargestellt, während die nicht-leitenden Fäden 2 aus Übersichtlichkeitsgründen weggelassen wurden. Um eine gewünschte Leiterbahn zu erzeugen wird an einer bestimmten Schnittstelle 4 zweier elektrisch leitender Fäden 3 die Isolierung durch einen Laser entfernt. Anschließend werden die abisolierten Stellen der beiden elektrisch leitenden Fäden 3 durch einen leitenden Kleber oder durch Lötzinn elektrisch leitend verbunden. So entsteht eine leitende Verbindungsstelle 14 zwischen zwei leitenden Fäden 3. Um eine erzeugte Leiterbahn räumlich zu begrenzen, können elektrisch leitende Fäden 3 an entsprechenden Stellen mit einem Schnitt 15 durchtrennt werden. Dieser Schnitt kann durch einen Laser erfolgen.

Die einzelnen elektrischen Bauelemente 10 weisen Anschlussanordnungen 12 auf. Diese Anschlussanordnungen 12 müssen mit den jeweiligen dafür vorgesehen elektrisch leitenden Fäden 3 verbunden werden. Hierzu wird ebenfalls, wie bereits beschrieben, an einer definierten Stelle die Außenisolierung eines elektrisch leitenden Fadens 3 entfernt. Bevorzugt eignen sich hierfür Kreuzungspunkte. Diese Kontaktstellen werden mittels eines elektrisch leitenden Klebers mit einem Anschlusspunkt der Anschlussanordnung 12 elektrisch leitend verbunden. Dies erfolgt für jeden Anschlusspunkt eines elektrischen Bauelements 11.

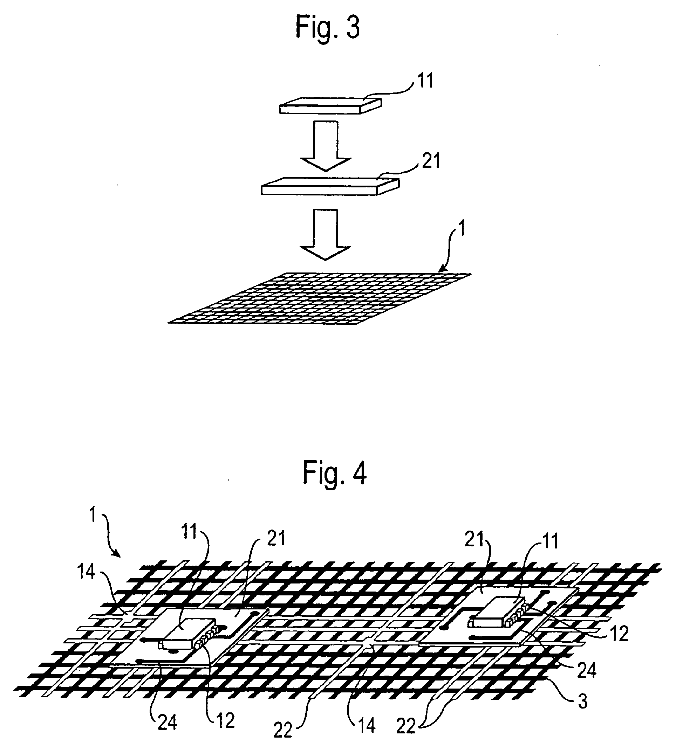

Zur leichteren Positionierung von Bauelementen 11 auf der sehr feinen Leiterplatte 1 ist in Fig. 3 ein Adapterelement 21 vorgesehen. Dieses Adapterelement 21 vereinfacht es, bei einem sehr engen Abstand 6 eine genaue Positionierung auf den gewünschten Kontaktierungspunkten auszuführen, da das Adapterelement 21 vorzugsweise größer ausgelegt ist als das Bauelement 11. Es entsteht durch das Adapterelement 21 eine bessere physikalische Verbindung mit der Leiterplatte 1. Ein weiterer Vorteil des Adapterelements 21 kann darin gesehen werden, dass das Adapterelement 21 genau auf die verwendete Leiterplatte 1 mit derem Abstand 6 angepasst werden kann und so eine einfachere Herstellung einer Schaltung mit der erfindungsgemäßen Leiterplatte 1 möglich ist. Die Oberseite des Adapterelements 21, auf der das Bauelement 11 angebracht wird, kann wiederum auf spezielle Bauelemente 11 angepasst sein. Auf das Adapterelement 21 kann dann das elektrische bzw. elektronische Bauelement 11 problemlos aufgesetzt werden.

Wie in Fig. 4 gezeigt, werden nicht alle elektrisch leitenden Fäden 3 einer Leiterplatte 1 zum Aufbau einer Verschaltung benötigt. (Hier sind wiederum nur die leitenden Fäden 3 dargestellt). In dieser Figur sind die verwendeten elektrisch leitenden Fäden 22 in grauer Farbe dargestellt. Auf dem gezeigten Leiterplattenabschnitt 1 sind zwei Bauelemente 11 mittels A-dapterelementen 21 auf der Leiterplatte 1 angebracht. Um die Kontaktierungspunkte zwischen dem Bauelement 11 und der Leiterplatte 1 zu entzerren, weist das Adapterelement 21 Leitungen 24 auf, die von den Anschlussanordnungen 12 zu den jeweiligen Verbindungspunkten mit der Leiterplatte 1 führen.

Weiterhin ist in dieser Figur gezeigt, dass Schnitte in leitenden Fäden 3 nicht immer notwendig sind. Durch geschicktes Nutzen der elektrisch leitenden Fäden 3 können Schnitte sogar vollkommen überflüssig werden. Dies ist vorteilhaft, da bei der Herstellung einer Verschaltung mit der erfindungsgemäßen Leiterplatte 1 ein Produktionsschritt entfallen kann, und so kostengünstiger und mit größerer Stabilität produziert werden kann.

Durch die erfindungsgemäße Leiterplatte, die aus elektrisch leitenden und elektrisch nicht-leitenden Fäden besteht, wird eine Komponente angegeben, die ähnlich einer herkömmlichen Leiterplatte verwendet werden kann, jedoch bei der Kombination mit Textilien kaum die Textileigenschaften des Trägermaterials beeinflusst oder verschlechtert.

## Patentansprüche

1. Flexible Leiterplatte (1), bei welcher elektrisch nicht-leitende Fäden (2) und elektrisch leitende Fäden (3), die mit einem elektrisch isolierenden Material ummantelt sind, zu einem Gewebe verwebt sind, wobei
mindestens die elektrisch leitenden Fäden (3) als Kett- und Schussfäden angeordnet sind,
**dadurch gekennzeichnet**
**dass** die elektrisch leitenden Fäden (3) eine Gitterstruktur mit einem regelmäßigen gleichen Abstand im gesamten Gewebe bilden und
**dass** die elektrisch nicht-leitenden Fäden (2) eine höhere Zugfestigkeit als die der elektrisch leitenden Fäden (3) aufweisen.

2. Leiterplatte nach Anspruch 1,
**dadurch gekennzeichnet,**
**dass** die elektrisch nicht-leitenden (2) und die elektrisch leitenden Fäden (3) einen Durchmesser zwischen 0,5 µm bis 500 µm aufweisen.

3. Leiterplatte nach Anspruch 1 oder 2,
**dadurch gekennzeichnet,**
**dass** das Gewebe eine Maschenweite (5) von 1 µm bis 1 mm aufweist und
**dass** das Gewebe eine Dicke von 1 µm bis 1 mm aufweist.

4. Leiterplatte nach einem der Ansprüche 1 bis 3,
**dadurch gekennzeichnet,**
**dass** die elektrisch leitenden Fäden (3) einen Kern aufweisen, insbesondere aus Kupfer, Messing, Aluminium oder Polypyrrol.

5. Leiterplatte nach Anspruch 4,
**dadurch gekennzeichnet,**
**dass** der Kern der elektrisch leitenden Fäden (3) mit Silber und/oder Gold überzogen ist.

6. Leiterplatte nach einem der Ansprüche 1 bis 5,
**dadurch gekennzeichnet,**
**dass** das elektrisch isolierende Material, welches die elektrisch leitenden Fäden (3) umgibt, Kunststoff, insbesondere Polyethylen, Polyurethan, Polyester oder Polyamid umfasst.

7. Leiterplatte nach einem der Ansprüche 1 bis 6,
**dadurch gekennzeichnet,**
**dass** das Gewebe Mono- und/oder Multifilamentfäden aufweist, welche aus elektrisch nicht-leitenden und/oder elektrisch leitenden Fasern aufgebaut sind.

8. Leiterplatte nach einem der Ansprüche 1 bis 7,
**dadurch gekennzeichnet,**
**dass** die Gitterstruktur, die durch die leitenden Fäden (3) gebildet wird, in Schuss- wie in Kettrichtung den gleichen Abstand (6) aufweist und
**dass** der Abstand (6) zwischen 5 µm bis 4 mm groß ist.

9. Leiterplatte nach einem der Ansprüche 1 bis 8,
**dadurch gekennzeichnet,**
**dass** das Gewebe mehr nicht-leitende Fäden (2) als leitende Fäden (3) aufweist.

10. Leiterplatte nach einem der Ansprüche 1 bis 9,
**dadurch gekennzeichnet,**
**dass** mindestens ein Adapterelement (21) auf der Leiterplatte (1) in elektrisch leitenden Kontakt mit mindestens einem der elektrisch leitenden Fäden (3) aufgebracht ist und
**dass** auf dem Adapterelement (21) mindestens ein elektrisch und/oder elektronisches Bauelement (11) befestigt ist.

11. Textil aus mindestens zwei Lagen,
**dadurch gekennzeichnet,**
**dass** mindestens eine Lage eine Leiterplatte (1) nach einem der Ansprüche 1 bis 10 ist.

12. Textil nach Anspruch 11,
**dadurch gekennzeichnet,**
**dass** mindestens eine Lage aus einer Folie, einem Gewebe oder einem Filz besteht.

13. Verfahren zur Herstellung einer flexiblen Leiterplatte (1) nach einem der Ansprüche 1 bis 10, bei dem elektrisch nicht-leitende Fäden (2) und elektrisch leitende Fäden (3), die mit einem elektrisch isolierenden Material ummantelt sind, zu einem Gewebe verwebt werden und
mindestens die elektrisch leitenden Fäden (3) als Kett- und Schussfäden angeordnet werden,
**dadurch gekennzeichnet,**
**dass** die verwebten elektrisch leitenden Fäden in einer regelmäßigen Gitterstruktur im gesamten Gewebe mit einem regelmäßig gleichen Abstand angeordnet werden, und
**dass** die elektrisch nicht-leitenden Fäden (2) eine höhere Zugfestigkeit als die der elektrisch leitenden Fäden (3) aufweisen.

14. Verfahren nach Anspruch 13,
**dadurch gekennzeichnet,**
**dass** eine gewünschte Leitungsstruktur durch Verbinden und/oder Trennen von bestimmten elektrisch leitenden Fäden (3) gebildet wird.

## Claims

1. Flexible circuit board (1), in which electrically non-conductive threads (2) and electrically conductive threads (3), which are sheathed with an electrically insulating material, are woven to a fabric, wherein at least the electrically conductive threads (3) are arranged as warp threads and weft threads,
**characterized in that**
the electrically conductive treads (3) form a mesh structure with a regular equal spacing in the entire fabric, and
**in that** the electrically non-conductive threads (2) have a higher tensile strength than the electrically conductive threads (3).

2. Circuit board according to claim 1,
**characterized in that**
the electrically non-conductive threads (2) and the electrically conductive threads (3) have a diameter ranging between 0.5 µm and 500 µm.

3. Circuit board according to claim 1 or 2,
**characterized in that**
the fabric has a mesh width (5) from 1 µm to 1 mm and **in that** the fabric has a thickness from 1 µm to 1 mm.

4. Circuit board according to any one of claims 1 to 3,
**characterized in that**
the electrically conductive threads (3) have a core, in particular made of copper, brass, aluminium or polypyrrole.

5. Circuit board according to claim 4,
**characterized in that**
the core of the electrically conductive threads (3) is coated with silver and/or gold.

6. Circuit board according to one of claims 1 to 5,
**characterized in that**
the electrically insulating material that envelops the electrically conductive threads (3) comprises plastic, in particular polyethylene, polyurethane, polyester or polyamide.

7. Circuit board according to any one of claims 1 to 6,
**characterized in that**
the fabric comprises monofilament threads and/or multifilament threads consisting of electrically non-conductive and/or electrically conductive fibres.

8. Circuit board according to any one of claims 1 to 7,
**characterized in that**
the mesh structure formed by the conductive threads (3) has the same spacing (6) both in the weft thread and in the warp thread direction, and
**in that** the spacing (6) ranges between 5 µm and 4 mm.

9. Circuit board according to any one of claims 1 to 8,
**characterized in that**
the fabric comprises more non-conductive threads (2) than conductive threads (3).

10. Circuit board according to any one of claims 1 to 9,
**characterized in that**
at least one adapter element (21) is applied to the circuit board (1) in electrically conductive contact with at least one of the electrically conductive threads (3), and
**in that** at least one electric and/or electronic component (11) is mounted on the adapter element (21).

11. Textile consisting of at least two layers,
**characterized in that**
at least one layer is constituted by a circuit board (1) according to any one of claims 1 to 10.

12. Textile according to claim 11,
**characterized in that**
at least one layer consists of a film, a fabric or a felt.

13. Method for producing a flexible circuit board (1) according to any one of claims 1 to 10, in which electrically non-conductive threads (2) and electrically conductive threads (3), which are sheathed with an electrically insulating material, are woven to a fabric, and in which at least the electrically conductive threads (3) are arranged as warp threads and weft threads,
**characterized in that**
the woven electrically conductive threads are arranged in a regular mesh structure in the entire fabric with a regular equal spacing, and
the electrically non-conductive threads (2) have a higher tensile strength than the electrically conductive threads (3).

14. Method according to claim 13,
**characterized in that**
a desired line structure is formed by connecting and/or disconnecting particular electrically conductive threads (3).

## Revendications

1. Circuit imprimé souple (1), dans lequel des fils non conducteurs électriques (2) et des fils conducteurs électriques (3), qui sont enrobés dans un matériau isolant électrique, sont tissés en un tissu, dans lequel
au moins les fils conducteurs électriques (3) sont disposés en fils de chaîne et fils de trame,
***caractérisé***
***en ce que*** les fils conducteurs électriques (3) forment une structure en réseau avec une distance régulière dans tout le tissu, et
**en ce que** les fils non conducteurs électriques (2) présentent une plus grande résistance à la traction que les fils conducteurs électriques (3).

2. Circuit imprimé selon la revendication 1, ***caractérisé en ce que*** les fils non conducteurs électriques (2) et les fils conducteurs électriques (3) présentent un diamètre compris entre 0,5 µm et 500 µm.

3. Circuit imprimé selon la revendication 1 ou 2, ***caractérisé***
***en ce que*** le tissu présente une largeur (5) de maille de 1 µm à 1 mm et
***en ce que*** le tissu présente une épaisseur de 1 µm à 1 mm.

4. Circuit imprimé selon l'une quelconque des revendications 1 à 3, ***caractérisé en ce que*** les fils conducteurs électriques (3) comprennent une âme, en particulier en cuivre, laiton, aluminium ou polypyrrole.

5. Circuit imprimé selon la revendication 4, ***caractérisé en ce que*** l'âme des fils conducteurs électriques (3) est revêtue d'argent et/ou d'or.

6. Circuit imprimé selon l'une quelconque des revendications 1 à 5, ***caractérisé en ce que*** le matériau isolant électrique qui entoure les fils conducteurs électriques (3) comprend une matière plastique, en particulier du polyéthylène, du polyuréthane, du polyester ou du polyamide.

7. Circuit imprimé selon l'une quelconque des revendications 1 à 6, ***caractérisé en ce que*** le tissu présente des fils monofilament et/ou multifilament, qui sont constitués de fibres non conductrices électriques et/ou conductrices électriques.

8. Circuit imprimé selon l'une quelconque des revendications 1 à 7, ***caractérisé***
***en ce que*** la structure en réseau qui est formée par les fils conducteurs (3) présente la même distance (6) dans la direction de la trame et dans la direction de la chaîne, et
**en ce que** la distance (6) est comprise entre 5 µm et 4 mm.

9. Circuit imprimé selon l'une quelconque des revendications 1 à 8, ***caractérisé en ce que*** le tissu présente plus de fils non conducteurs (2) que de fils conducteurs (3).

10. Circuit imprimé selon l'une quelconque des revendications 1 à 9,
***caractérisé***
***en ce qu'***au moins un élément adaptateur (21) est appliqué sur le circuit imprimé (1) en contact électrique avec au moins l'un des fils conducteurs électriques (3), et
***en ce que*** sur l'élément adaptateur (21) est fixé au moins un composant électrique et/ou électronique (11).

11. Textile constitué d'au moins deux couches,
***caractérisé en ce qu'***au moins une couche est un circuit imprimé (1) selon l'une quelconque des revendications 1 à 10.

12. Textile selon la revendication 11, ***caractérisé en ce qu'***au moins une couche est constituée d'une feuille, d'un tissu ou d'un feutre.

13. Procédé de fabrication d'un circuit imprimé souple (1) selon l'une quelconque des revendications 1 à 10, dans lequel des fils non conducteurs électriques (2) et des fils conducteurs électriques (3) qui sont enrobés d'un matériau isolant électrique, sont tissés en un tissu,
au moins les fils conducteurs électriques (3) sont disposés, en fils de chaîne et fils de trame,
***caractérisé***
***en ce que*** les fils conducteurs électriques tissés sont disposés selon une structure régulière en réseau dans tout le tissu avec une distance régulière, et
***en ce que*** les fils non conducteurs électriques (2) présentent une plus grande résistance à la traction que les fils conducteurs électriques (3).

14. Procédé selon la revendication 13, ***caractérisé en ce qu'***une structure de conduction souhaitée est formée par jonction et/ou séparation de certains fils conducteurs électriques (3).
